(19) Europäisches Patentamt
European Patent Office
Office européen des brevets

(11) EP 3 199 969 A1

(12) EUROPEAN PATENT APPLICATION

(43) Date of publication:
02.08.2017 Bulletin 2017/31

(51) Int Cl.:
$G01R\ 33/565^{(2006.01)}$     $G06T\ 5/00^{(2006.01)}$
$G01R\ 33/56^{(2006.01)}$

(21) Application number: 17153252.6

(22) Date of filing: 26.01.2017

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
MA MD

(30) Priority: 27.01.2016 EP 16152932

(71) Applicant: Max-Planck-Gesellschaft zur
Förderung der
Wissenschaften e.V.
80539 München (DE)

(72) Inventors:
• LOKTYUSHIN, Alexander
72076 Tübingen (DE)
• EHSES, Philipp
72076 Tübingen (DE)
• SCHEFFLER, Klaus
72076 Tübingen (DE)
• SCHÖLKOPF, Bernhard
72076 Tübingen (DE)

(74) Representative: Bach, Alexander
Mitscherlich PartmbB
Patent- und Rechtsanwälte
Sonnenstraße 33
80331 München (DE)

(54) **AUTOFOCUSING-BASED CORRECTION OF B0 FLUCTUATION-INDUCED GHOSTING**

(57)     A method for correcting Bo fluctuation-induced
ghosting artifacts in long-TE gradient-echo scan images,
comprises the steps of
- acquiring a magnetic resonance image (u);
- determining, based on the magnetic resonance image
(u), one or more parameters characterizing phase offsets
($\Phi$, a, b) of the magnetic resonance image (u);
- correcting the magnetic resonance image (u), based on
the one or more parameters, in order to obtain a corrected
image (u');

According to the invention, the one or more parameters are determined, such that a metric of spatial intensity variations in the corrected image (u') decreases.

Fig. 1

**Description**

The present invention relates to autofocusing-based correction of Bo fluctuation-induced ghosting.

Long-TE gradient-echo images are prone to ghosting artifacts. Such degradation is primarily due to magnetic field variations caused by breathing or motion. The effect of these fluctuations amounts to different phase offsets in each acquired *k*-space line. In fact, phase artifacts, regardless of the chosen TE parameter, affect all scans. The longer TE, the more severe the artifacts are. A common remedy is to measure the problematic phase offsets using an extra non-phase-encoded scan before or after each imaging readout.

Brockstedt et al. ("High resolution diffusion imaging using phase-corrected segmented echo-planer imaging", MAGNETIC RESONANCE IMAGING; ELSEVIER SCIENCE, vol. 18, no. 6, 1 January 2000, p. 649 - 657) use navigator echo phase corrections, performed after a one-dimensional Fourier transform along the frequency-encoding direction in order to reduce motion artifacts. The navigator echoes are acquired together with the image. However, the use of navigators requires longer repetition duration, reducing the effective time during which relevant image data is acquired.

It is therefore an object of the present invention to develop a postprocessing method for gradient-echo scans, which is capable of removing Bo fluctuation-induced ghosting artifacts -, wherein the entire duration of the sequence repetition may be used to acquire image data.

The object is achieved by a method and a system according to the independent claims. Advantageous embodiments are defined in the subclaims. Particularly, the invention estimates the phase offsets directly from the raw image data by optimization-based search of phases that minimize an image quality measure. This eliminates the need for any sequence modifications and additional scan time.

In contrast to Brockstedt et al., the method of the invention is navigator free, which allows using the entire duration of the sequence repetition to acquire the image data. The image data alone may be used to estimate the unknown phase offsets.

The optimization problem is formulated and solved where one seeks the latent phase offsets in the Fourier domain that are associated with a minimal value of an image quality measure that is evaluated in the spatial domain. This way, the need for extra non-phase-encoded navigator scans and the related increase in sequence complexity and scan time may be avoided. The experimental results demonstrate that the inventive method is capable of removing the ghosting artifacts, and that the quality of the outcome images is similar to navigator-based reconstructions. To conclude, the proposed method is a valid alternative to using navigators with only a slight increase in post processing time.

These and other aspects of the present invention will be described in more detail in the following detailed description, in relation to the annexed drawing in which

Fig. 1    shows a comparison between uncorrected images with images corrected for Bo fluctuations using a conventional navigator-based approach as well as the proposed autofocusing-based method;

Fig. 2    shows the differences between the autofocusing and navigator-based approaches; and

Fig. 3    shows the differences between the autofocusing and navigator-based approaches.

According to an embodiment of the invention, equation 1 shows a navigator-less reconstruction formulated as an optimization problem, which involves finding the minimum value of the objective function:

$$\hat{\Phi} = \arg\min_{\Phi} \varphi\left(\left(G_x + G_y\right)SOS\left(F^H A_\Phi Q\right)\right) + \lambda\|G\Phi\|^2 \qquad (1)$$

The matrix $F^H$ denotes the inverse Fourier transform matrix and Q the acquired multi-coil raw data.

The unknown phase values $\Phi$ are searched that are associated with low values of the image quality measure or metric $\varphi$. More precisely, one computes the entropy $\phi(\cdot)$ of the spatial intensity variations in the SOS-combined image (sum of squares).

The described embodiment of the invention proposes to use an entropy $\phi(\cdot)$ of the image gradients as an image metric. Before computing the entropy, an edge-detection filter is applied to the image. More specifically, the differences between the neighboring voxels in spatial domain are computed in both X (readout) and Y (phase encode) directions, while skipping the Z (partition) direction. The matrices that are used to perform the finite difference operations in the *x* and *y* direction are denoted by $G_x$ and $G_y$, respectively. Their effect can be seen as a convolution of the image with a high pass filter [1-1] in both X and Y direction. The result is an image gradient, which emphasizes sharp structures such as edges.

Computing an image-metric on the spatial gradients rather than determining it on the raw pixel intensities is advantageous in the context of MRI, where an image not corrupted by phase artifacts has clean sharp transitions between the tissues (i.e. fat layer of the skull / air surrounding the head transition). Whenever, i.e. due to field distortions, an image is corrupted by ghosting artifacts, the edges become blurry and smeared out. This has an effect of increasing the variance in the gradient domain representation, and thus, increasing the entropy. Although the entropy evaluated on raw pixel intensities is also sensitive to ghosting and blurring artifacts, the inventors observed in experiments that the entropy of the gradients is associated with better reconstruction outcomes. The choice of the gradient entropy for MR image quality estimation was also found to be highly effective in a specialized study that evaluated and compared various image quality metrics - Kiaran McGee et al ("Image Metric-Based Correction of Motion Effects").

As an alternative image metric, a total variation or $L_1$ norm of the gradient image may be used instead of an entropy.

The phase values $\Phi$ are applied to the acquired images **Q** (for each coil element) using the diagonal matrix **A**, whose elements are the complex exponentials $exp(i\Phi_t)$, with $t$ being the repetition index, i.e. the number of the repetition as counted from the start of the acquisition.

In this formulation, the objective function is invariant to circular shifts of the image in the phase-encoding direction because such circular shifts amount to phase ramps - composed of recovered phases $\Phi$ - in the frequency domain. The problem of unnecessary circular shifts can be avoided by adding a regularization term, which penalizes strong variations of the recovered phases. The parameter X controls the strength of the regularization and may be set to 0.1.

The resulting non-linear optimization problem may be solved in 80 iterations of the LBFGSalgorithm (Byrd RH, Lu P, Nocedal J, Zhu C. A limited memory algorithm for bound constrained optimization. SIAM Journal on Scientific and Statistical Computing 1995;16:1190-1208). The operations were implemented from Eq. 1 on the GPU in CUDA, bringing the computation time for each slice down to a few seconds.

To evaluate the performance of the proposed method long-TE gradient-echo images were acquired of the brain of a healthy volunteer after obtaining informed consent and approval by the local ethics committee. Data was acquired at 9.4T using a custom-built head coil (16 transmit / 31 receive channels). 9 slices were acquired of the ventral portions of the brain where field variations are relatively severe, mainly due to breathing-related motion. The GRE sequence included a non-phase-encoded navigator (or phase-stabilization) scan after each imaging readout. The sequence parameters were as follows: TR = 356 ms, TE = 30 ms, nominal flip angle = 45°, matrix = 512x512, resolution = 0.4x0.4 mm$^2$, slice thickness = 1 mm.

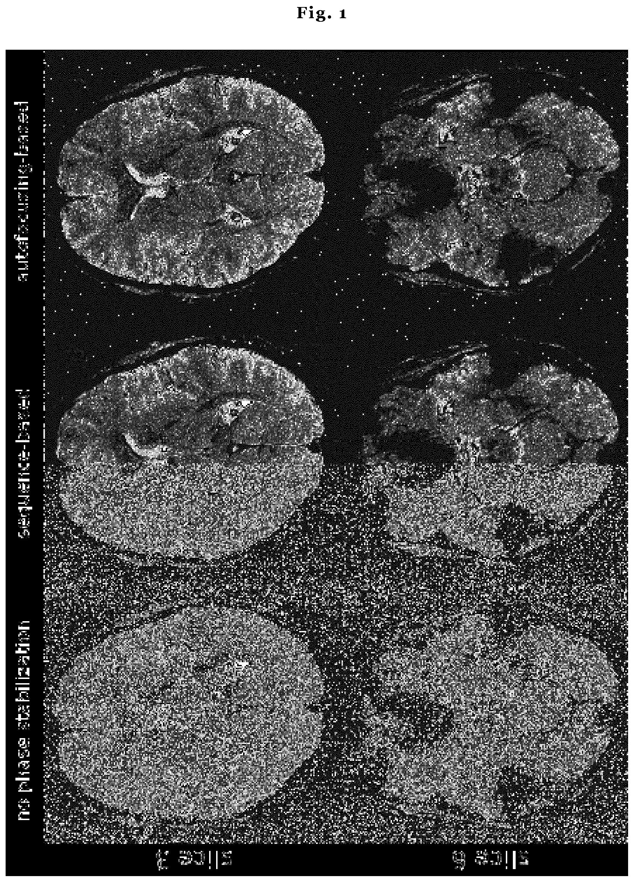

Figure 1 shows a comparison between uncorrected images with images corrected for Bo fluctuations using a conventional navigator-based approach as well as the proposed autofocusing-based method. Ghosting artifacts in the uncorrected data are more severe in slice 6 shown on the bottom, which is positioned lower than slice 3 (top). In both slices, autofocusing and navigator-based correction techniques are able to improve image quality significantly.

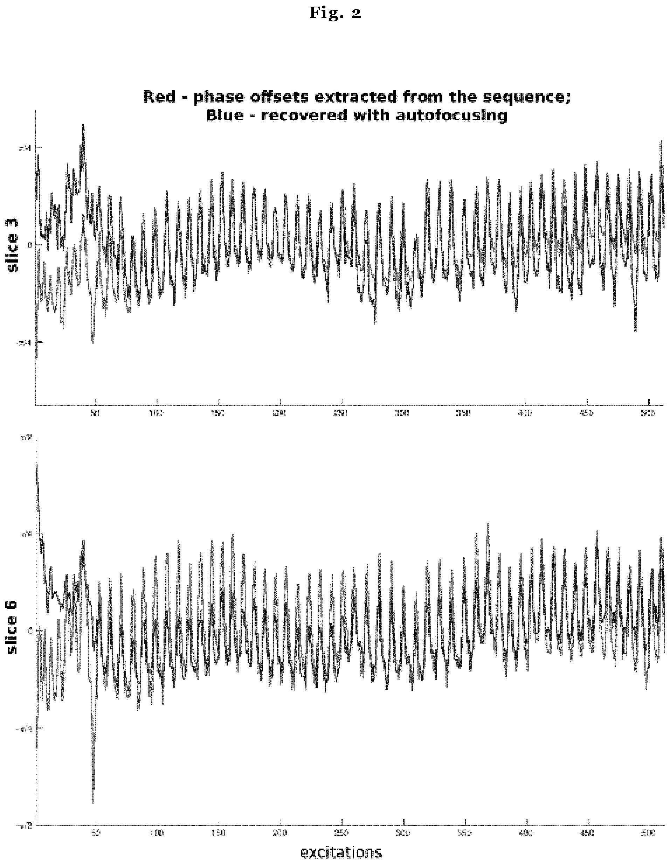

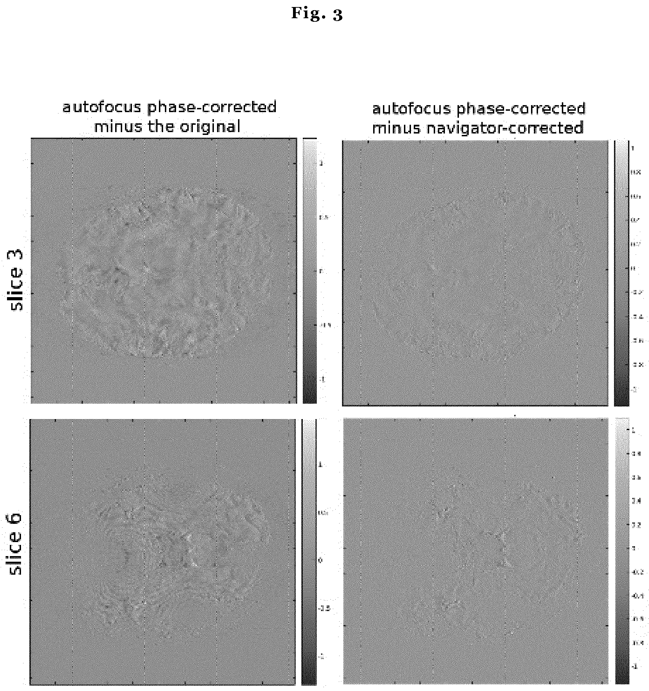

Apart from some flow-related artifacts, ghosting is completely removed and the images resulting from both techniques are practically indistinguishable from one another. In fact, the differences between the autofocusing and navigator-based approaches amount to the minute high-frequency details as illustrated in Figure 2. Figure 3 compares the phase offsets retrieved a method according to an embodiment of the invention with the navigator-based measurement.

Since there is a sign as well as a global phase offset ambiguity, the sign was adjusted and the mean was subtracted from both phase series before plotting them. Although there are a few differences in the recovered phase values, the general pattern of oscillations caused by breathing is the same.

According to a second embodiment of the invention, the phase artifact correction technique of the invention can be naturally extended to cover the problem of even-odd ghosting artifacts in EPI scans. There, the ghosts are displaced by N/2 voxels in phase encode direction due to asymmetry between the odd and even echoes. The asymmetry arises because of field inhomogeneities, eddy currents, or imperfect gradient waveforms. The ghosting artifacts are caused by relative shifts of even and odd k-space segments and in the spatial domain can be modeled by linear phase ramps:

$$q = M_{odd} F(p_{a.b} * u) + M_{even} F(u) \qquad (2)$$

Here, **q** is the single-coil phase-corrupted image in Fourier domain, **F** is discrete Fourier transform matrix, $\mathbf{p_{a,b}}$ is a linear phase ramp in spatial domain, **u** is phase-artifact free image in the spatial domain, and $\mathbf{M_{odd}}$ and $\mathbf{M_{even}}$ are diagonal matrices that extract odd and even segments in the frequency domain. The operator * denotes component-wise multiplication. The field distortions make the segments acquired in the frequency domain translated against the origin in read direction. The amount of translation depends on the strength of the field distortions. According to the present embodiment of the invention, such translations are modeled in the spatial domain with phase ramps i.e. the spatial dual of Fourier translations. The parameter *a* controls the slope of the ramp, and *b* determines the offset. Thus,

$p_{a,b}$ (x)= exp(iax+b), where x is the spatial coordinate, and i is imaginary unit The problem of finding unknown ramp parameters can be formulated in the following way:

$$a,b = \arg\min_{a,b} \varphi\left(\left(G_x + G_y\right) SOS\left(p_{a,b} * F^H M_{odd} Q + F^H M_{even} Q\right)\right) \qquad (3)$$

Here, SOS is sum-of-squares coil combination method, $\varphi$ is an image quality estimator, and **Q** is the matrix that contains coil images in frequency domain representation. Once the parameters *a* and *b* are recovered, they can be used to correct the image for even-odd ghosting artifacts.

## Claims

1. Method for correcting $B_o$ fluctuation-induced ghosting artifacts in long-TE gradient-echo scan images, comprising the steps of

    - acquiring a magnetic resonance image (u);
    - determining, based on the magnetic resonance image (u), one or more parameters characterizing phase offsets (Φ, a, b) of the magnetic resonance image (u);
    - correcting the magnetic resonance image (u), based on the one or more parameters, in order to obtain a corrected image (u');

    **characterized in that**
    the one or more parameters are determined, such that a metric of spatial intensity variations in the corrected image (u') decreases.

2. The method of claim 1, wherein the metric is an entropy metric.

3. The method of claim 1, wherein the metric is a total variation metric.

4. The method of claim 1, wherein the one or more parameters are determined only based on the acquired image (u).

5. The method of claim 1, wherein the phase offsets are determined using the LBFGS algorithm.

6. The method of claim 1, implemented on a GPU in CUDA.

7. The method of claim 1, wherein $B_o$ = 9,4 Tesla.

8. The method of claim 1, wherein a regularization term is added for penalizing strong variations of the recovered phases.

9. Device for correcting $B_o$ fluctuation-induced ghosting artifacts in long-TE gradient-echo scan images, comprising:

    - an image acquisition unit for acquiring a magnetic resonance image (u);
    - a phase offset determining unit for determining, based on the acquired magnetic resonance image (u), one or more parameters characterizing phase offsets (Φ) of the magnetic resonance image;
    - an image correction unit for correcting the image (u), based on the one or more parameters, in order to obtain a corrected image (u');

    **characterized in that**
    the one or more parameters of the magnetic resonance image are determined such that a metric of the spatial intensity variations in the corrected image (u) decreases.

Fig. 1

**Fig. 2**

Red - phase offsets extracted from the sequence;
Blue - recovered with autofocusing

Fig. 3

Europäisches
Patentamt

European
Patent Office

Office européen
des brevets

# EUROPEAN SEARCH REPORT

Application Number

EP 17 15 3252

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X,P | LOKTYUSHIN A. ET AL.: "Autofocuisng-based correction of B0 fluctuation-induced ghosting",<br>PROCEEDINGS OF THE INTERNATIONAL SOCIETY FOR MAGNETIC RESONANCE IN MEDICINE, 24TH ANNUAL MEETING & EXHIBITION,<br>no. 1848, 7 May 2016 (2016-05-07),<br>XP040682890,<br>Singapore<br>* the whole document * | 1,2,4-9 | INV.<br>G01R33/565<br>G06T5/00<br><br>ADD.<br>G01R33/56 |
| X | US 7 728 757 B2 (CHO KWANG M [US])<br>1 June 2010 (2010-06-01)<br>* column 2, line 31 - line 57 *<br>* column 4, line 23 - line 35 *<br>* column 6, line 10 - column 7, line 21 *<br>* column 8, line 60 - column 11, line 49; claim 1 * | 9 | |
| A | BROCKSTEDT SARA ET AL: "High-resolution diffusion imaging using phase-corrected segmented echo-planer imaging",<br>MAGNETIC RESONANCE IMAGING, ELSEVIER SCIENCE, TARRYTOWN, NY, US,<br>vol. 18, no. 6, July 2000 (2000-07), pages 649-657, XP002967687,<br>ISSN: 0730-725X, DOI:<br>10.1016/S0730-725X(00)00159-4<br>* sections 1, 2.2 and 4 * | 1,6,7 | TECHNICAL FIELDS SEARCHED (IPC)<br><br>G01R<br>G06T |

-/--

The present search report has been drawn up for all claims

| Place of search | Date of completion of the search | Examiner |
|---|---|---|
| Munich | 20 June 2017 | Skalla, Jörg |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 1 of 3

Europäisches
Patentamt

European
Patent Office

Office européen
des brevets

## EUROPEAN SEARCH REPORT

Application Number

EP 17 15 3252

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | ALEXANDER LOKTYUSHIN ET AL: "Blind retrospective motion correction of MR images", MAGNETIC RESONANCE IN MEDICINE., vol. 70, no. 6, 11 February 2013 (2013-02-11), pages 1608-1618, XP055288829, US ISSN: 0740-3194, DOI: 10.1002/mrm.24615 * the whole document * | 1-9 | |
| A | MCGEE K P ET AL: "Image metric-based correction (autocorrection) of motion effects: analysis of image metrics", JOURNAL OF MAGNETIC RESONANCE IMAGING, SOCIETY FOR MAGNETIC RESONANCE IMAGING, OAK BROOK, IL, US, vol. 11, no. 2, February 2000 (2000-02), pages 174-181, XP002276109, ISSN: 1053-1807, DOI: 10.1002/(SICI)1522-2586(200002)11:2<174::AID-JMRI15>3.0.CO;2-3 * the whole document * | 1-9 | |
| A | LIN W ET AL: "Improved optimization strategies for autofocusing motion compensation in MRI via the analysis of image metric maps", MAGNETIC RESONANCE IMAGING, ELSEVIER SCIENCE, TARRYTOWN, NY, US, vol. 24, no. 6, July 2006 (2006-07), pages 751-760, XP028004862, ISSN: 0730-725X, DOI: 10.1016/J.MRI.2006.02.003 [retrieved on 2006-07-01] * the whole document * | 1-9 | |

TECHNICAL FIELDS
SEARCHED      (IPC)

-/--

The present search report has been drawn up for all claims

| Place of search | Date of completion of the search | Examiner |
|---|---|---|
| Munich | 20 June 2017 | Skalla, Jörg |

EPO FORM 1503 03.82 (P04C01)

Europäisches
Patentamt

European
Patent Office

Office européen
des brevets

## EUROPEAN SEARCH REPORT

Application Number

EP 17 15 3252

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | DAVID ATKINSON ET AL: "Automatic Correction of Motion Artifacts in Magnetic Resonance Images Using an Entropy Focus Criterion", IEEE TRANSACTIONS ON MEDICAL IMAGING, IEEE SERVICE CENTER, PISCATAWAY, NJ, US, vol. 16, no. 6, December 1997 (1997-12), XP011035675, ISSN: 0278-0062 * the whole document * | 1-9 | |

-----

TECHNICAL FIELDS
SEARCHED    (IPC)

The present search report has been drawn up for all claims

| Place of search | Date of completion of the search | Examiner |
|---|---|---|
| Munich | 20 June 2017 | Skalla, Jörg |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

page 3 of 3

## ANNEX TO THE EUROPEAN SEARCH REPORT
## ON EUROPEAN PATENT APPLICATION NO.

EP 17 15 3252

This annex lists the patent family members relating to the patent documents cited in  the above-mentioned European search report.
The members are as contained in the European Patent Office EDP file on
The European Patent Office is in no way liable for these particulars which are merely given for the purpose of information.

20-06-2017

| Patent document cited in search report | | Publication date | Patent family member(s) | | Publication date |
|---|---|---|---|---|---|
| US 7728757 | B2 | 01-06-2010 | GB | 2460755 A | 16-12-2009 |
| | | | US | 2009303111 A1 | 10-12-2009 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- High resolution diffusion imaging using phase-corrected segmented echo-planer imaging. **BROCKSTEDT et al.** MAGNETIC RESONANCE IMAGING. ELSEVIER SCIENCE, 01 January 2000, vol. 18, 649-657

- **KIARAN MCGEE et al.** *Image Metric-Based Correction of Motion Effects*
- **BYRD RH ; LU P ; NOCEDAL J ; ZHU C.** A limited memory algorithm for bound constrained optimization. *SIAM Journal on Scientific and Statistical Computing,* 1995, vol. 16, 1190-1208